# EUROPEAN PATENT APPLICATION

(11) **EP 2 192 619 A1**
(43) Date of publication of application: **02.06.2010**
(21) Application number: 08832752.3
(22) Date of filing: 17.09.2008
(51) Int. Cl.: H01L 31/04

(54) **THIN-FILM SOLAR CELL DEVICE AND METHOD FOR MANUFACTURING THE SAME**

(30) Priority: 18.09.2007 JP 2007240480
(71) Applicant: Mitsubishi Electric Corporation, Chiyoda-ku Tokyo 100-8310 (JP)
(72) Inventor: YAMAMUKA, Mikio, Tokyo 100-8310 (JP); ORITA, Tae, Tokyo 100-8310 (JP); YAMARIN, Hiroya, Tokyo 100-8310 (JP)
(74) Representative: Popp, Eugen
(86) International application number: PCT/JP2008/066757
(87) International publication number: WO 2009/038083

(57) **Abstract**

It is an object of the present invention to achieve a thin film solar cell device of higher power generation efficiency, and particularly, the present invention is applied to a thin film solar call device having a tandem structure in which a transparent electrode layer is inserted between a back surface electrode layer and a photoelectric conversion layer and between a plurality of stacked photoelectric conversion layers. A first electricity conducting path (6) is obtained by forming a thin film made of a conductive material (of which the specific resistance < 10⁻⁴ Ωcm) in a micropore penetrating an intermediate transparent electrode layer (4) and a first insulating layer (5), for electrically connecting a first photoelectric conversion layer (3) and a second photoelectric conversion layer (7) to each other. A second electricity conducting path (16) having the same structure also electrically connects the second photoelectric conversion layer (7) and a back surface electrode layer (9) to each other. The gross area of an electricity conducting path constituted of the first electricity conducting path (6) and the second electricity conducting path (16) is set in a range not less than 1×10⁻⁷ and not more than 4×10⁻⁶ relative to the area of the cell. The conductive material is any one of platinum, gold, chromium, ruthenium, and titanium nitride.

## Description

### Technical Field

The present invention relates to a stacked-type thin film solar cell device comprising a plurality of stages of photoelectric conversion layers each for converting an incident light into electricity and transparent electrode layers each for multiply reflecting light to be sufficiently absorbed in the photoelectric conversion layers, and a method of manufacturing the same.

### Background Art

A photovoltaic power generation system is expected as a system for generating clean energy which serves to protect the global environment in the 21 century against an increase of CO₂ gas due to the burning of fossil energy, and its production increases explosively all over the world. For this reason, there arises a situation where silicon wafers run short in the world, and in recent years, the production of thin film solar cells not depending on the supply of silicon wafers is fast increasing.

In thin film solar cells, conventionally, in order to widely and effectively use the solar spectrum, a tandem structure has been adopted in which a plurality of photoelectric conversion layers (semiconductor layers) formed of materials of different band gaps are stacked on an insulating translucent substrate. Now studies are made to increase the power generation efficiency of a solar cell by producing the "light confinement effect" in which an incident light is multiply reflected in the solar cell so that its optical path may be extended and the light may be sufficiently absorbed in the photoelectric conversion layers. For this reason, studies are proceeding on a structure of a thin film solar cell device in which a transparent electrode layer is inserted between a back surface electrode layer and a photoelectric conversion layer and between a plurality of stacked photoelectric conversion layers (see Patent Documents 1 and 2).

Patent Document 1: Japanese Patent Application Laid Open Gazette No. 2002-222972
Patent Document 2: Japanese Patent Application Laid Open Gazette No. 2002-208715

In the thin film solar cell device according to the above precedent (Patent Document 1 and 2), the transparent electrode layer which is inserted for the purpose of light confinement is formed in close contact with the photoelectric conversion layer (semiconductor layer). The material of the transparent electrode is generally an oxide-based, and when these thin films are formed directly on the semiconductor layer by the CVD method, the sputtering method, the vacuum deposition method or the like, an insulating layer (an oxide of the semiconductor layer) is formed in the portion of an interface of these films. For this reason, a contact resistance is generated due to the insulating layer, and inside the solar cell device, there arises a problem that the series resistance component thereby increases and the short circuit current density decreases, whereby the power generation efficiency decreases.

In the above precedent (Patent Document 2), in order to suppress the generation of such an insulating layer, it tries to form the transparent electrode film (ITO) may be formed by a sputtering process in which the oxygen concentration is lowered. It is difficult, however, to suppress the oxidation reaction (on a surface of the semiconductor layer) caused by the oxygen atoms contained in the sputter target (ITO), and the effect can be hardly expected.

### Disclosure of Invention

The present invention is intended to solve the above problem, and it is a main object of the present invention to achieve a thin film solar cell device having higher power generation efficiency.

The present invention is intended for a thin film solar cell device, and according to an aspect of the present invention, a thin film solar cell device has a photoelectric conversion layer provided between a front surface transparent electrode layer and a back surface metal electrode layer, being formed of a semiconductor layer film of which the main ingredient is silicon and a transparent electrode layer provided between the photoelectric conversion layer and the back surface metal electrode layer, of which the main ingredient is an oxide, and in the thin film solar cell device, the transparent electrode layer has a through hole and a conductive member provided in the through hole, being formed of a nonoxide in contact with the photoelectric conversion layer and the back surface metal electrode layer.

By the aspect of the present invention, since the through hole filled with the conductive member is formed as an electricity conducting path in the transparent electrode layer inserted between the back surface metal electrode and the photoelectric conversion layer, it is possible to reduce the effect of the contact resistance caused by the insulating layer (the oxide of the semiconductor layer) formed in an interface between the transparent electrode layer and the photoelectric conversion layer and maximally draw out the generated current.

Further, by the aspect of the present invention, it is possible to produce the effect of forming the above-discussed through hole in the transparent electrode layer by the cheapest and easiest method.

These and other objects, features, aspects and advantages of the present invention will become more apparent from the following detailed description of the present invention when taken in conjunction with the accompanying drawings.

### Brief Description of Drawings

[Fig. 1] shows a longitudinal section and a bird's eye view of one cell in a thin film solar cell device in accordance with a first preferred embodiment of the present invention;
[Fig. 2] shows graphs each indicating a relation between the short circuit current density obtained in the thin film solar cell device in accordance with the first preferred embodiment and the gross area of electricity conducting paths;
[Fig. 3] shows longitudinal sections illustrating a flow of manufacturing one cell in the thin film solar cell device in a second preferred embodiment;
[Fig. 4] shows longitudinal sections illustrating the flow of manufacturing one cell in the thin film solar cell device in the second preferred embodiment;
[Fig. 5] shows longitudinal sections illustrating a flow of manufacturing micropores for electricity conducting paths in accordance with a third preferred embodiment;
[Fig. 6] is a view showing a manner of depositing mask fine particles on a surface of the transparent electrode layer in a fourth preferred embodiment;
[Fig. 7] is a graph showing the respective dependences of the amounts of electric charges in the mask fine particles and the transparent electrode layer on a pH value in the fourth preferred embodiment; and
[Fig. 8] is a plan view showing deposition state of the mask fine particles on the surface of the transparent electrode layer in the fourth preferred embodiment.

### Best Mode for Carrying Out the Invention

### (The First Preferred Embodiment)

The characteristic feature of the first preferred embodiment is to provide electricity conducting paths each formed of a conductive material different from a transparent electrode material in a back surface transparent electrode layer and an intermediate transparent electrode layer in a thin film solar cell device having a tandem structure consisting of the back surface transparent electrode layer and the intermediate transparent electrode layer for confining light in a power generation region. Hereinafter, the characteristic feature will be discussed with reference to figures.

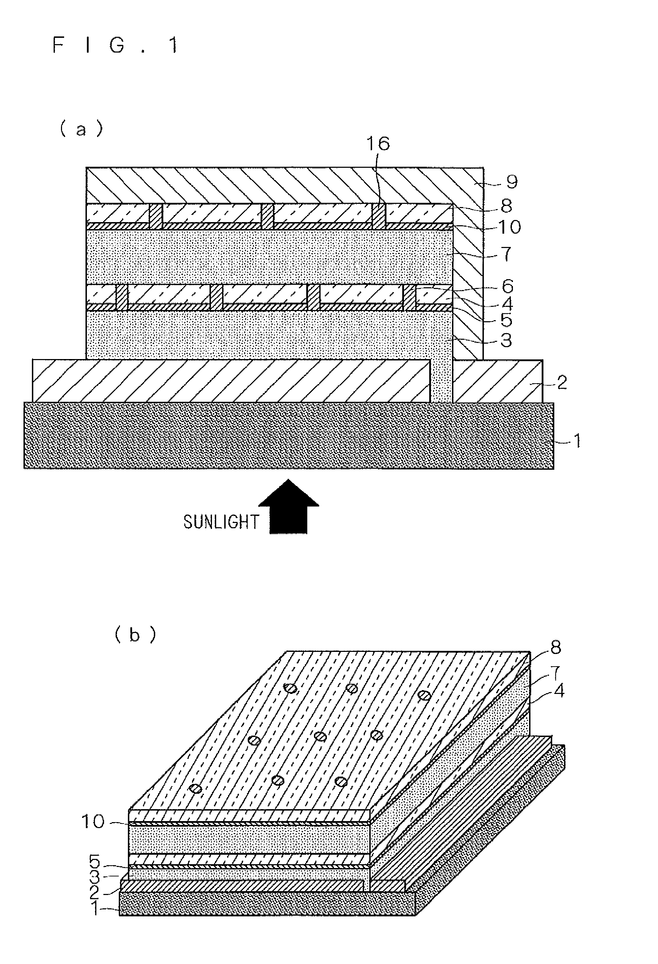

Fig. 1(a) is a longitudinal section showing a structure of one cell in the thin film solar cell device in accordance with the first preferred embodiment of the present invention. In Fig. 1(a), on an upper surface of an insulating translucent substrate 1 formed of, e.g., a glass substrate, a front surface electrode layer (which corresponds to a front surface transparent electrode layer) 2, a first photoelectric conversion layer 3, an intermediate transparent electrode layer 4, a second photoelectric conversion layer 7, a back surface transparent electrode layer 8, and a back surface metal electrode layer 9 are stacked in this order. A first insulating layer 5 is formed in an interface between the intermediate transparent electrode layer 4 and the first photoelectric conversion layer 3 and a second insulating layer 10 is formed in an interface between the back surface transparent electrode layer 8 and the second photoelectric conversion layer 7. When sunlight enters from a back side of the insulating translucent substrate 1, free carriers are generated in the first photoelectric conversion layer 3 and the second photoelectric conversion layer 7, to thereby generate current. Each of the first photoelectric conversion layer 3 and the second photoelectric conversion layer 7 has a three-layer structure of p-i-n type consisting of crystalline silicon-based semiconductor films or amorphous silicon-based semiconductor films. Each of the intermediate transparent electrode layer 4 and the back surface transparent electrode layer 8 is formed of an oxide-based transparent conductive film and specifically is a transparent conductive film formed of a material containing any one of zinc oxide, ITO, and SnO₂. The intermediate transparent electrode layer 4 and the back surface transparent electrode layer 8 each have a film thickness set in a range not less than 150 nm and not more than 200 nm. It is known that light entering the power generation region is reflected on the transparent electrode layers 4 and 8 with high efficiency when the film thickness is set in the range.

The first insulating layer 5 and the second insulating layer 10 are silicon oxide films which are unintentionally formed by oxidation of surfaces of the silicon-based semiconductor films when and after the intermediate transparent electrode layer 4 and the back surface transparent electrode layer 8 which are oxide-based transparent conductive films are formed. Though the first insulating layer 5 and the second insulating layer 10 each have a thickness in Fig, 1(a) for easy understanding, the first insulating layer 5 and the second insulating layer 10 are actually very thinner than the transparent conductive layers. By the formation of these insulating layers, the resistance between the first photoelectric conversion layer 3 and the second photoelectric conversion layer 7 and the resistance between the second photoelectric conversion layer 7 and the back surface metal electrode layer 9 increase.

Then, in the intermediate transparent electrode layer 4, a first electricity conducting path 6 penetrating the intermediate transparent electrode layer 4 is formed. The first electricity conducting path 6 also penetrates the first insulating layer 5 formed immediately below the intermediate transparent electrode layer 4 and is connected to an upper surface of the first photoelectric conversion layer 3. Therefore, the first electricity conducting path 6 electrically connects the first photoelectric conversion layer 3 and the second photoelectric conversion layer 7 to each other, which are opposed to each other with the intermediate transparent electrode layer 4 and the first insulating layer 5 interposed therebetween.

Similarly, in the back surface transparent electrode layer 8, a second electricity conducting path 16 penetrating the back surface transparent electrode layer 8 is formed. The second electricity conducting path 16 also penetrates the second insulating layer 10 formed immediately below the back surface transparent electrode layer 8 and is connected to an upper surface of the second photoelectric conversion layer 7. Therefore, the second electricity conducting path 16 electrically connects the second photoelectric conversion layer 7 and the back surface electrode layer 9 to each other, which are opposed to each other with the back surface transparent electrode layer 8 and the second insulating layer 10 interposed there between.

Due to the presence of the first electricity conducting path 6 and the second electricity conducting path 16, the current generated in the first photoelectric conversion layer 3 flows through the first electricity conducting path 6 into the second photoelectric conversion layer 7 without being affected by the first insulating layer 5. This generated current, together with the current generated in the second photoelectric conversion layer 7, flows through the second electricity conducting path 16 to the back surface electrode layer 9 without being affected by the second insulating layer 10 and is drawn out from the back surface electrode layer 9. The first electricity conducting path 6 and the second electricity conducting path 16 are formed, as discussed later in the second preferred embodiment, by a method in which micropores penetrating the intermediate transparent electrode layer 4 and the back surface transparent electrode layer 8 are formed in the intermediate transparent electrode layer 4 and the back surface transparent electrode layer 8, respectively, and then thin films each made of a conductive material are formed thereon to thereby fill the micropores with the conductive members. The micropore is, e.g., a round hole having a diameter ranging from 0.2 µm to 10 µm. The conductive members forming the both electricity conducting paths 6 and 16 each is formed of a conductive material which have a specific resistance not more than 10⁻¹ Ωcm (since the intermediate transparent electrode layer 4 and the back surface transparent electrode layer 8 each have a specific resistance not more than 10⁻⁴ Ωcm, the specific resistance of the material for the both electricity conducting paths 6 and 16 is also set to the same value as the specific resistance of the intermediate transparent electrode layer 4 and the back surface transparent electrode layer 8), is a nonoxide-based material containing no oxygen, can be formed in an atmosphere where no oxygen exists, and is not oxidized even if it is exposed to oxygen or maintains its conductivity even if it is oxidized. Among such conductive materials are, for example, metals such as platinum, gold, chromium and ruthenium, and conductive nitride, such as a titanium nitride. In a case of forming a lot of electricity conducting paths in the transparent electrode, it is preferable to make the distribution almost uniform.

Fig. 1(b) is a perspective view showing the structure of Fig. 1(a) as the one cell in the thin film solar cell device except the back surface electrode layer 9 is viewed from diagonally upward. It can be seen that the electricity conducting paths 16 are formed in the back surface transparent electrode layer 8. The one cell is a unit power generation element in a solar cell, which is formed of continuous photoelectric conversion layers, and in an ordinary solar cell, the one cell has an area of, e.g., about 0.01 m². In the ordinary solar cell, a plurality of cells are connected in series.

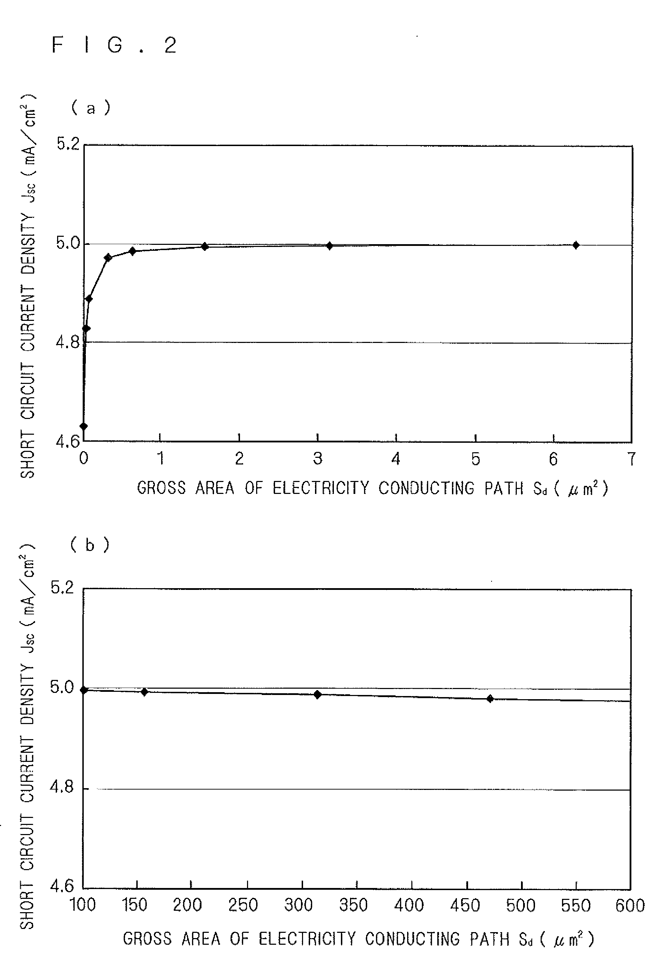

Figs. 2(a) and 2(b) are graphs showing respective relations between the short circuit current density J_{sc} and the gross area S_{d} of the electricity conducting paths per one cell in the thin film solar cell device shown in Figs. 1(a) and 1(b) as the gross area S_{d} of the electricity conducting paths per one cell in the thin film solar cell device changes in a range from 0 to 7 µm² and in another range from 100 µm² to 600 µm². In this case, the short circuit current density J_{sc} is estimated by using an equivalent circuit of the solar cell device assuming that 1) the maximum current density generated in the photoelectric conversion layer per one cell when light is emitted is 5 mA/cm², 2) the thickness of the transparent electrode layer is 100 nm, 3) the parallel resistance component of the cell is 100 Ω, 4) the specific resistance of the electricity conducting path is 10⁻⁴ Ωcm, 5) the specific resistance of the insulating layer is 10¹² Ωcm, and 6) the gross area of one cell which is a square having a side of 5 mm is 25 mm².

In Fig. 2(a), the short circuit current density J_{sc} sharply increases in a range of the gross area S_{d} from 0 to 0.5 µ m² and is saturated at 5 mA/cm² when the gross area S_{d} becomes more them 2.5 µ m² or more. In other words, by providing the electricity conducting paths in each transparent electrode layer, it is possible to fully draw out the current generated in the solar cell. On the other hand, Fig. 2(b) shows the relation between the short circuit current density J_{sc} and the gross area S_{d} as the gross area S_{d} changes in the range from 100 µm² to 600 µm². It can be seen from Fig. 2(b) that the short circuit current density J_{sc} decreases as the gross area S_{d} increases when the gross area S_{d} becomes more than 100 µm², This is because the incident light is blocked by the electricity conducting path formed in the transparent electrode layer, not entering the semiconductor layer, and the amount of current generated in a power generation layer thereby decreases.

Thus, by forming the electricity conducting paths of which the gross area S_{d} is in the range of 2.5 µ m² ≦ S_{d} ≦ 100 µ m² per one cell of which the area is 25 mm² in the transparent electrode layer of the thin film solar cell device, it is possible to achieve the maximum short circuit current density (power generation efficiency). Herein, if a plurality of electricity conducting paths [for example, nine second electricity conducting paths 16 in Fig. 1(b)] are formed per one cell as shown in Fig. 1, there is no restriction per the area of one electricity conducting path. The electricity conducting paths have only to be formed so that the gross area per one cell [the gross area of the nine electricity conducting paths in Fig. 1(b)] may fall within the range of 2.5 µ m²≦S_{d}≦ 100 µ m². Specifically, the ratio of the gross area of the through holes to the area of the cell has only to be set in a range not less than 1 × 10⁻⁷ and not more than 4 × 10⁻⁶. Only if the gross area ratio to the area of one cell is in the above range, there is particularly no restriction on the number of electricity conducting paths.

The above-discussed characteristic structual feature may be applied to a case where two or more intermediate transparent electrode layers and two or more corresponding photoelectric conversion layers stacked on the intermediate transparent electrode layers, respectively, are formed in the power generation region, and this produces the same effect.

Though the solar cell has the tandem structure in which the first photoelectric conversion layer 3 and the second photoelectric conversion layer 7 are stacked in the direction of layer thickness in the first preferred embodiment, the same effect can be produced even by another structure in which only one photoelectric conversion layer is formed and the above-discussed electricity conducting paths are formed in the transparent electrode layer between the photoelectric conversion layer and the back surface metal electrode layer. Further, the same effect can be also produced by still another structure in which the above-discussed electricity conducting paths are formed only in the intermediate transparent electrode layer between the first photoelectric conversion layer 3 and the second photoelectric conversion layer 7 in the tandem type solar cell.

### (The Second Preferred Embodiment)

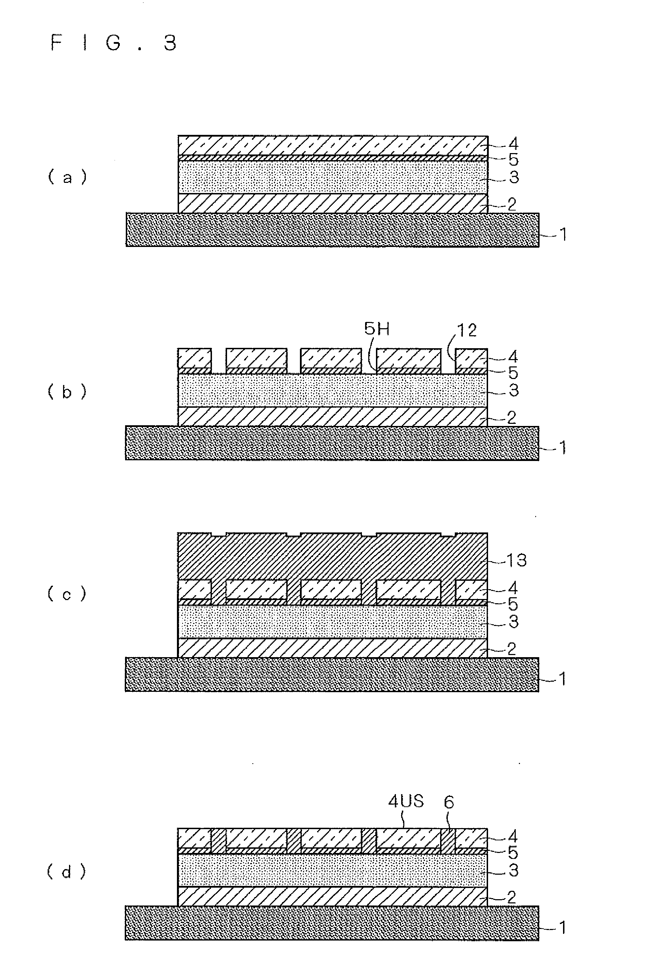

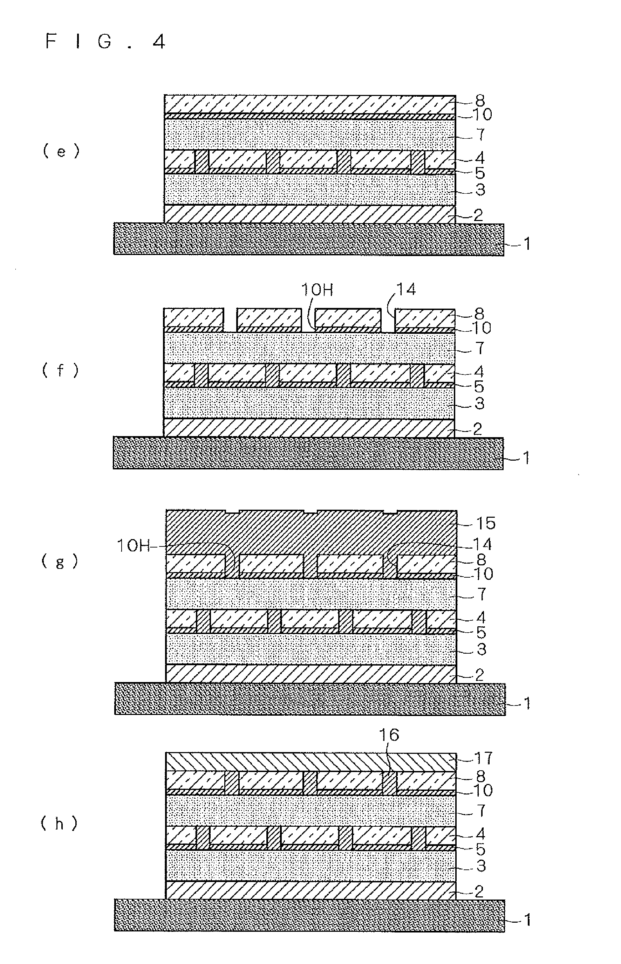

Figs. 3(a) to 3(d) and 4(e) to 4(h) are process longitudinal sections showing a flow of manufacturing the thin film solar cell device having the structure discussed in the first preferred embodiment.

As shown in Fig. 3(a), first, on the upper surface of the insulating translucent substrate 1, the front surface electrode layer 2, the first photoelectric conversion layer 3, and the intermediate transparent electrode layer 4 are stacked. When the intermediate transparent electrode layer 4 is stacked, the first insulating layer 5 is formed and inserted in the interface between the layers 3 and 4. It is preferable that the front surface electrode layer 2 and the intermediate transparent electrode layer 4 should be each formed of a material containing zinc oxide, ITO, or SnO₂, and the first photoelectric conversion layer (power generation layer) 3 should have a three-layer structure of p-i-n type consisting of crystalline silicon-based semiconductor films or amorphous silicon-based semiconductor films.

Next, as shown in Fig. 3(b), micropores 12 of several micron size are formed in the intermediate transparent electrode layer 4, and then portions of the insulating layer 5 which are positioned immediately below respective bottom surfaces of the micropores 12 are etch-removed by a plasma treatment in a fluorine-containing gas such as CF₄ or SF₆ with a pattern of the intermediate transparent electrode layer 4 provided with the micropores 12 used as an etching mask, to thereby form micropores 5H continuous with the micropores 12, respectively, in the first insulating layer 5.

Next, as shown in Fig. 3(c), a sufficiently thick conductive film layer 13 is formed above the micropores 12 and the intermediate transparent electrode layer 4, to thereby fully fill the micropores 12 and 5H with the conductive film. At that time, the conductive film layer 13 is formed sufficiently thick so that the effect of the forms of the micropores 12 may disappear in the upper surface. It is preferable that the material of the conductive film layer 13 should be platinum, gold, chromium, ruthenium, titanium nitride, or the like.

Then, as shown in Fig. 3(d), the conductive film layer 13 is removed by full etch-back until an upper surface 4US of the intermediate transparent electrode layer 4 appears, to thereby form the first electricity conducting paths 6.

Herein, the full etch-back may be performed by using, e.g., ion milling, RIE, or the like. Exposure of the transparent electrode surface can be detected by, for example, the change in the intensity of surface-reflected light obtained by emitting light to a surface of the conductive film layer 13 during the etching.

Next, as shown in Fig. 4(e), the second photoelectric conversion layer 7 and the back surface transparent electrode layer 8 are stacked. When the back surface transparent electrode layer 8 is stacked, the second insulating layer 10 is formed and inserted in the interface between the layers 7 and 8. It is preferable that the back surface transparent electrode layer 8 should be formed of a material containing zinc oxide, ITO, or SnO₂, and the second photoelectric conversion layer 7 should have a three-layer structure of p-i-n type consisting of crystalline silicon-based semiconductor films or amorphous silicon-based semiconductor films.

Next, as shown in Fig. 4(f), micropores 14 of micron size are formed in the back surface transparent electrode layer 8, and then portions of the second insulating layer 10 which are positioned immediately below respective bottom surfaces of the micropores 14 are etch-removed by a plasma treatment in a fluorine-containing gas such as CF₄ or SF₆ with a pattern of the back surface transparent electrode layer 8 provided with the micropores 14 used as a mask, to thereby form micropores 10H spatially continuous with the micropores 14, respectively, in the second insulating layer 10.

Next, as shown in Fig. 4(g), a sufficiently thick conductive film layer 15 is formed above the micropores 14 and the back surface transparent electrode layer 8, to thereby fully fill the micropores 14 and 10H with the conductive film. Also herein, it is preferable that the material of the conductive film layer 15 should be platinum, gold, chromium, ruthenium, titanium nitride, or the like.

Then, as shown in Fig. 4(h), the conductive film layer 15 is removed by full etch-back until an upper surface of the back surface transparent electrode layer 8 appears, to thereby form the second electricity conducting paths 16.

Finally, a back surface electrode layer 17 is formed on upper surfaces of the back surface transparent electrode layer 8 and the second electricity conducting paths 16. It is preferable that the back surface electrode layer 17 should be formed of silver or aluminum.

Through the above process steps, the structure of one cell of the thin film solar cell device shown in Fig. 1 can be formed.

### (The Third Preferred Embodiment)

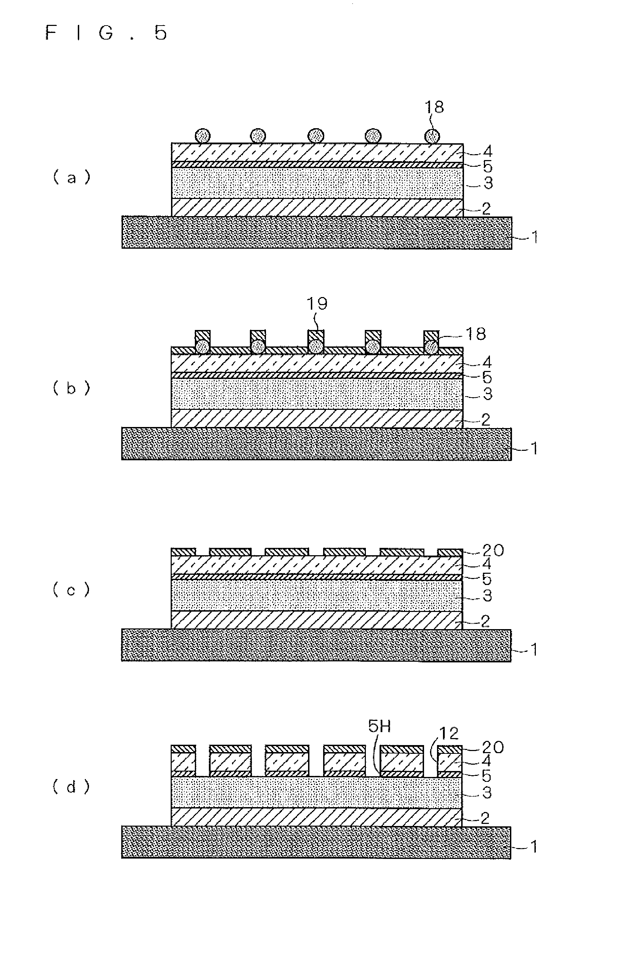

Fig. 5 shows process longitudinal sections illustrating a flow of manufacturing method to form the micropores for the electricity conducting paths [the micropore 12 in Fig. 3(b) and the micropores 14 in Fig. 4(f)] in the transparent electrode layer by the easiest and low-cost method. Herein, as a representative example, a method of forming the micropores 12 in the intermediate transparent electrode layer 4 will be discussed below.

As discussed in the first preferred embodiment, in order to achieve the maximum short circuit current density, it is necessary to form the electricity conducting paths with the ratio of the gross area of the electricity conducting paths to the area of the cell set in a range not less than 1×10⁻⁷ and not more than 4×10⁻⁶. For this, it is required that the micropores of several micron size, for example, the micropores each having a side not more than 10 µm when the cross section of each of the micropores is regarded as square or the micropores each having a diameter not more than 10 µm, should be formed in the transparent electrode layers. Even if only one electricity conducting path is provided in one cell, it is naturally necessary to form the micropores each having, for example, a diameter not more than 10 µm, It is preferable that the micropore should have a diameter almost equal to or larger than the thickness of the transparent conductive film. If the diameter of the micropore is smaller than the thickness of the transparent conductive film, it becomes difficult to fill the micropore with a film to become the conducting path. Since the thickness of the transparent conductive film is set within the range not less than 150 nm and not more than 200 nm as discussed above, the internal diameter of the micropore has only to be 0.2 µm or more.

Usually, such a micropore is formed generally by patterning using a photolithography technique. In the thin film solar cell device, however, generally, a plurality of solar battery cells are formed on a glass substrate having a large area of 1.5 m square (a surface area of 1.5 m×1.5 m) as an insulating translucent substrate. Such a glass substrate has large surface waviness (0.05 nm or more per 30 cm) and it is therefore impossible to accurately form supermicropores each having a diameter of 10 µm or less by using the photolithography technique.

Then, as shown in 5(a), first, mask fine particles 18 each having the same diameter as that of the micropore to be formed are deposited on a surface of the uppermost intermediate transparent electrode layer 4 among the front surface electrode layer 2, the first photoelectric conversion layer 3, the first insulating layer 5, and the intermediate transparent electrode layer 4 which are stacked on the insulating translucent substrate 1. Herein, if the mask fine particles 18 are deposited in a liquid, it is preferable that a material which tends to become positively charged in the liquid should be used. It may be formed of an insulator such as polystyrene or grass, or oxide ceramics such as alumina or silicon oxide if the liquid is water-based one. Since such a material as above is burned out when exposed to plasma in oxygen, the material is suitable as a mask material to be used for forming a secondary mask discussed later.

Next, as shown in Fig. 5(b), a hard mask layer 19 is so formed on surfaces of the mask fine particles 18 and on the surface of the intermediate transparent electrode layer 4 between adjacent mask fine particles 18 as to cover the mask fine particles 18.

Then, as shown in Fig. 5(c), a secondary mask layer 20 is formed on the surface of the intermediate transparent electrode layer 4 by exposing the mask fine particles 18 to plasma in oxygen to be burned out and removed (with this, the portion of the hard mask layer 19 on the surface of the mask fine particles 18 falls off to be removed). Using titanium or aluminum as the material for the secondary mask layer 20 (the hard mask layer 19) allows more accurate processing.

Finally, as shown in Fig. 5(d), by using the secondary mask layer 20 as a mask, the intermediate transparent electrode layer 4 and the first insulating layer 5 are processed to form the micropores 12 and the micropores 5H of the first insulating layer 5 which are spatially continuous with the micropores 12. At that time, the intermediate transparent electrode layer 4 can be selectively etched by using a weak acid aqueous solution, such as an oxalic acid aqueous solution, as an etchant. The first insulating layer 5 is processed by dry etching in fluorine-containing gas plasma. After that, the secondary mask layer 20 is removed.

Thus, by applying the process steps discussed in the third preferred embodiment, it is possible to most easily form the micropores each having a diameter of 10 µ m or less. Further, it is possible to accurately form the supermicropores each having a diameter of 10 µm or less even on the insulating translucent substrate having large surface waviness. Moreover, it is possible to manufacture the thin film solar cell device without using the photolithography technique.

### (The Fourth Preferred Embodiment)

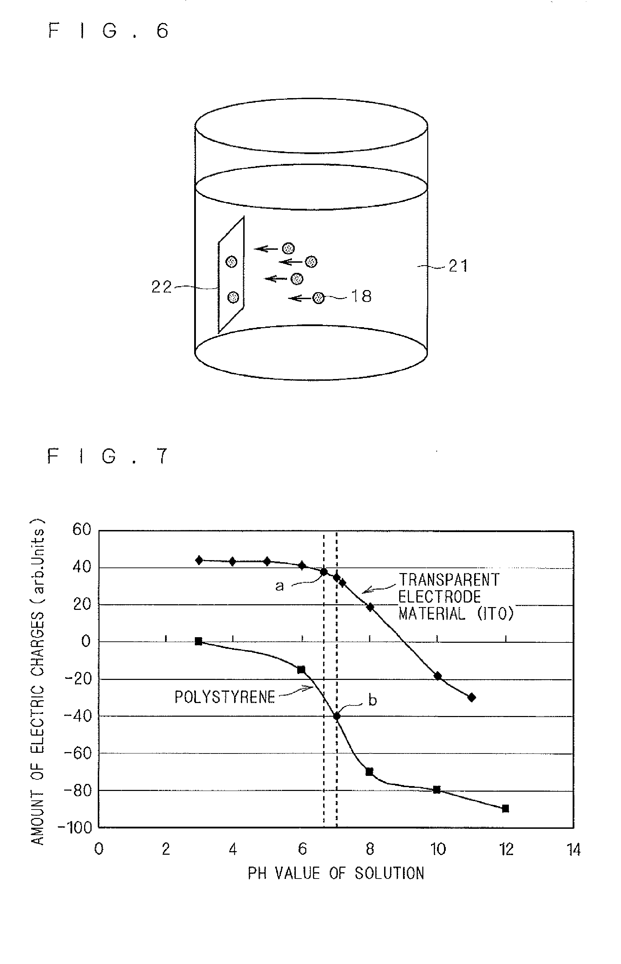

Fig. 6 is a view showing a manner of depositing the mask fine particles 18 on the transparent electrode layer in the flow of forming the micropores for the electricity conducting paths (the process step (a) in Fig. 5) discussed in the third preferred embodiment. First, a liquid 21 in which the mask fine particles 18 each having the same diameter as that of the micropore to be formed are dispersed is prepared and a substrate 22 on which the transparent electrode layer is formed as the uppermost layer is soaked in the liquid 21. The colloidal mask fine particles 18 are thereby charged with electricity having polarity different from that of the transparent electrode layer and the mask fine particles 18 are attracted by Coulomb force and deposited on the transparent electrode layer of the substrate 22. It is preferable to use an aqueous solution with its ion concentration controlled as the liquid 21 in order to make the colloidal dispersion of the mask fine particles 18 easy.

Herein, an exemplary case using the mask fine particles consisting of polystyrene and the transparent electrode consisting of ITO is shown in Fig. 6. The respective amounts of electric charges on the polystyrene and the ITO have such behaviors with respect to the pH value of the solution as shown in Fig. 6. It can be seen from Fig. 6 that the levels of "a" and "b" (absolute values of the amounts of electric charges) in Fig. 6 are almost equal in a case where the pH value of the solution ranges from 6.5 to 7.0. In this case, the amount of electric charges on the mask fine particles and the amount of electric charges on the ITO electrode are reasonably balanced with each other, and the mask fine particles and the ITO electrode can be charged with the maximum amounts and opposite polarities.

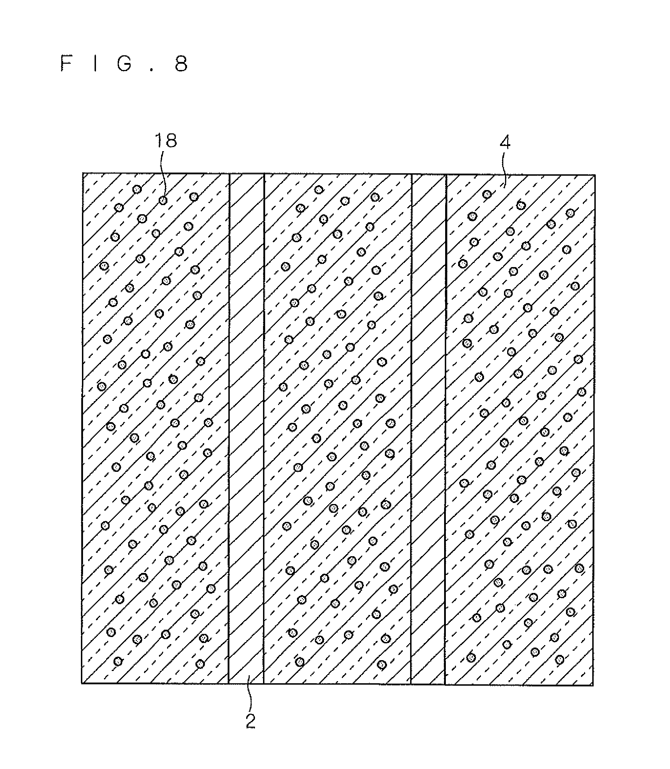

As a result, it is possible to most efficiently attract the mask fine particles to the transparent electrode layer and selectively deposit the mask fine particles on the surface of the transparent electrode layer. Since the fine particles repel one another by the Coulomb repulsion, it is possible to deposit the mask fine particles 18 uniformly on the surface of the intermediate transparent electrode layer 4 with equal distance apart from one another without being flocculated in mid-course as shown in Fig. 8.

### (Notes)

While the invention has been shown and described in detail, the foregoing description is in all aspects illustrative and not restrictive. It is therefore understood that numerous modifications and variations can be devised without departing from the scope of the invention.

Though the photoelectric conversion layer has a three-layer structure of p-i-n type consisting of microcrystalline silicon-based semiconductor layer films or amorphous silicon semiconductor films in the above preferred embodiments, the same effect can be produced only if the photoelectric conversion layer has a main ingredient of silicon, and a photoelectric conversion layer formed of, e.g., silicon with germanium or other element may be used.

### Industrial Applicability

The present invention is favorably applied to a photovoltaic power generation system.

## Claims

1. A thin film solar cell device having a photoelectric conversion layer provided between a front surface transparent electrode layer and a back surface metal electrode layer, being formed of a semiconductor layer film of which the main ingredient, is silicon, and a transparent electrode layer, of which the main ingredient is an oxide, provided between said photoelectric conversion layer and said back surface metal electrode layer,
wherein said transparent electrode layer has a through hole,
a conductive member provided in said through hole, being formed of a nonoxide in contact with said photoelectric conversion layer and said back surface metal electrode layed.

2. A thin film solar cell device having at least two photoelectric conversion layers overlapping each other provided between a front surface transparent electrode layer and a back surface metal electrode layer, each being formed of a semiconductor layer film of which the main ingredient is silicon, and a transparent electrode layer, of which the main ingredient is an oxide, provided between said photoelectric conversion layers,
wherein said transparent electrode layer has a through hole,
a conductive member provided in said through hole, being formed of a nonoxide in contact with said two photoelectric conversion layers.

3. The thin film solar cell device according to claim 1 or 2, wherein
the ratio of the gross area of said through hole to the area of said thin film solar cell device is set in a range not less than 1×10⁻⁷ and not more than 4×10⁻⁶.

4. The thin film solar cell device according to claim 1 or 2, wherein
said nonoxide is any one of platinum, gold, chromium, ruthenium, and titanium nitride.

5. A method of manufacturing a thin film solar cell device having a photoelectric conversion layer provided between a front surface transparent electrode layer and a back surface metal electrode layer, being formed of a semiconductor layer film of which the main ingredient is silicon, and a transparent electrode layer, of which the main ingredient is an oxide, provided between said photoelectric conversion layer and said back surface metal electrode layer, comprising the steps of:
forming said transparent electrode layer on said photoelectric conversion layer;
forming a through hole in said transparent electrode layer;
removing a silicon oxide film on a bottom surface of said through hole;
filing a conductive member formed of a nonoxide into said through hole of said transparent electrode layer; and
forming said back surface metal electrode layer on said transparent electrode layer and said conductive member.

6. A method of manufacturing a thin film solar cell device having at least two photoelectric conversion layers overlapping each other on a front surface side and a back surface side provided between a front surface transparent electrode layer and a back surface metal electrode layer, each being formed of a semiconductor layer film of which the main ingredient is silicon, and a transparent electrode layer, of which the main ingredient is an oxide, provided between said photoelectric conversion layers, comprising the steps of:
forming said transparent electrode layer on said photoelectric conversion layer of said front surface side;
forming a through hole in said transparent electrode layer;
removing a silicon oxide film on a bottom surface of said through hole;
filling a conductive member formed of a nonoxide into said through hole of said transparent electrode layer; and
forming said photoelectric conversion layer of said back surface side on said transparent electrode layer and said conductive member.

7. The method of manufacturing a thin film solar cell device according to claim 5 or 6, wherein
said step of forming said through hole comprises the steps of:
depositing particles on said transparent electrode layer;
forming a secondary mask layer on said transparent electrode layer by using said particles as a mask; and
etching said transparent electrode layer by using aid secondary mask layer.

8. The method of manufacturing a thin film solar cell device according to claim 7,
wherein
said step of depositing particles on said transparent electrode layer is a step of
depositing by soaking said transparent electrode layer in a liquid in which said particles are dispersed.
